# FASCICULE DE BREVET EUROPEEN

(11) **EP 3 692 415 B1**
(45) Date de publication et mention de la délivrance du brevet: **03.11.2021**
(21) Numéro de dépôt: 18778535.7
(22) Date de dépôt: 02.10.2018
(51) Int. Cl.: G02F 2/00, H03B 17/00

(54) **OSCILLATEUR RADIOFRÉQUENCE ET SOURCE ET APPAREIL ASSOCIÉS**
HOCHFREQUENZ-OSZILLATOR UND ZUGEHÖRIGE QUELLE UND VORRICHTUNG
RADIOFREQUENCY OSCILLATOR AND ASSOCIATED SOURCE AND APPARATUS

(30) Priorité: 02.10.2017 FR 1700998
(43) Date de publication de la demande: 12.08.2020
(73) Titulaire: Thales, 92400 Courbevoie (FR); Université Paris-Saclay, 91190 Saint-Aubin (FR); Centre National de la Recherche Scientifique, 75016 Paris (FR)
(72) Inventeur: COMBRIE, Sylvain, 91767 Palaiseau Cedex (FR); DE ROSSI, Alfredo, 91767 Palaiseau Cedex (FR); ANANE, Abdelmadjid, 91767 Palaiseau (FR); BORTOLOTTI, Paolo, 91767 Palaiseau (FR)
(74) Mandataire: Lavoix
(86) Numéro de dépôt international: PCT/EP2018/076870
(87) Numéro de publication internationale: WO 2019/068740

(56) Documents cités:
- WO-A1-2017/136459
- US-A1- 2011 150 485
- DEYCH LEV ET AL: "Resonant enhancement of magneto-optical polarization conversion in microdisk resonators", APPLIED PHYSICS LETTERS, A I P PUBLISHING LLC, US, vol. 99, no. 24, 12 décembre 2011 (2011-12-12), pages 241107-241107, XP012152689, ISSN: 0003-6951, DOI: 10.1063/1.3670354 [extrait le 2011-12-13]
- WANG Z ET AL: "Suppressing the effect of disorders using time-reversal symmetry breaking in magneto-optical photonic crystals: An illustration with a four-port circulator", PHOTONICS AND NANOSTRUCTURES, ELSEVIER, AMSTERDAM, NL, vol. 4, no. 3, 1 août 2006 (2006-08-01), pages 132-140, XP024978073, ISSN: 1569-4410, DOI: 10.1016/J.PHOTONICS.2006.02.001 [extrait le 2006-08-01]

## Description

La présente invention concerne un oscillateur radiofréquence. La présente invention se rapporte également à une source et un appareil associés.

Pour différentes applications, notamment pour les systèmes radar, le système de communication et la métrologie, il est souhaitable de disposer de générateurs de signaux radiofréquence présentant une grande pureté spectrale et utilisables comme oscillateur local.

Pour générer des signaux radiofréquences, il est connu d'utiliser un quartz dont la fréquence référence est multipliée pour atteindre une gamme de fréquence située dans les GigaHertz (GHz).

Toutefois, un tel dispositif est encombrant notamment parce que l'intégration monolithique d'un quartz sur un circuit pose des problèmes techniques, le quartz étant un élément discret.

Par ailleurs, l'opération de multiplication de la fréquence conduit aussi à la multiplication du bruit du fait de l'augmentation des fluctuations impliquées. Ceci est d'autant plus vrai que l'écart entre la fréquence d'origine et la fréquence souhaitée est grand.

Il est également utilisé des dispositifs optiques. De tels dispositifs reposent sur le battement de deux faisceaux optiques, dont l'écartement en fréquence se situe dans le domaine des radiofréquences.

Il est ainsi connu une première approche consistant à faire interférer deux sources lasers indépendantes, pouvant être des lasers externes ou réalisées sur une même puce. Chaque laser est alors soumis de manière indépendante à des fluctuations liées à des variations locales de température, de gain ou de battement avec des modes parasites. Les deux sources de bruit étant indépendantes du fait de la séparation physique, le bruit se reporte directement sur la fréquence générée.

La première approche consistant à utiliser le battement de deux sources lasers indépendantes est ainsi limitée par les fluctuations inhérentes à chaque source qui se reportent directement sur le signal de battement.

Selon une deuxième approche appelée « laser bi-fréquence », il est utilisé un laser opérant sur deux modes simultanément et dont l'écartement spectral correspond à la fréquence souhaitée. Dans ce cas, les deux modes partagent la même cavité et le même milieu à gain. Les fluctuations sont alors communes ce qui a pour conséquence de corréler les fluctuations. La fréquence différence est alors grandement stabilisée. Un tel type de laser a été développé avec une technologie type état solide. L'écartement entre modes est contrôlé en appliquant une tension aux bornes d'un élément biréfringent inséré dans la cavité laser.

Néanmoins, il est fait appel à des tensions de commande importantes (jusqu'à 100 Volts) dans la deuxième approche.

En outre, dans chacune des approches, il est utilisé des composants discrets, ce qui implique un système relativement encombrant. Le document US 2011 150485 décrit un oscillateur radiofréquence comprenant un résonateur en anneau réalisé en un matériau électro-optique.

Il existe donc un besoin pour une source radiofréquence présentant une meilleure compacité et une meilleure stabilité.

Pour cela, la présente description porte notamment sur un oscillateur radiofréquence comprenant un résonateur optique étant un guide d'ondes en anneau permettant la propagation d'une première onde dans un premier sens et d'une deuxième onde dans un deuxième sens, le deuxième sens étant opposé au premier sens, et le résonateur comportant un milieu optique actif générant une première raie optique à partir de la première onde et une deuxième raie à partir de la deuxième onde, le résonateur étant en contact avec une partie réalisée en un matériau à effet magnéto-optique. L'oscillateur radiofréquence comprend un applicateur de champ magnétique externe d'intensité réglable sur le résonateur générant un décalage en fréquence entre la première onde et la deuxième onde, et un circuit de traitement convertissant le battement entre les deux raies optiques en un signal radiofréquence.

Suivant des modes de réalisation particuliers, l'oscillateur radiofréquence comprend une ou plusieurs des caractéristiques suivantes, prise(s) isolément ou suivant toutes les combinaisons techniquement possibles :
- le matériau à effet magnéto-optique est du grenat d'yttrium et de fer ou du grenat d'yttrium et de fer dopé avec un élément ferromagnétique, paramagnétique, ferrimagnétique ou métallique.
- le circuit de traitement est réalisé dans une technologie silicium.
- l'applicateur est adapté à appliquer un champ magnétique perpendiculaire au guide d'ondes en anneau lorsque les deux ondes se propagent selon une polarisation transverse électrique.
- il est défini un centre pour le résonateur, l'applicateur étant adapté à appliquer un champ magnétique radial par rapport au centre du résonateur lorsque les deux ondes se propagent selon une polarisation transverse magnétique.
- la partie réalisée en un matériau à effet magnéto-optique fait partie du résonateur et est en contact avec le milieu optique actif.
- l'oscillateur comporte, en outre, une stabilisation en amplitude en fréquence et en phase.
- le milieu optique actif est positionné de manière à ce que le résonateur soit une cavité étendue.

La présente description concerne aussi une source radiofréquence comportant un oscillateur radiofréquence tel que précédemment décrit.

La présente description porte aussi sur un appareil comportant une source radiofréquence telle que précédemment décrite.

D'autres caractéristiques et avantages de l'invention apparaîtront à la lecture de la description qui suit, de modes de réalisation de l'invention, donnée à titre d'exemple uniquement et en référence aux dessins qui sont :
- figure 1, une vue en perspective d'un exemple d'oscillateur radiofréquence comportant notamment un résonateur en anneau, un guide optique d'extraction et une boucle électrique ;
- figure 2, une vue de l'oscillateur de la figure 1, la vue étant une vue en section selon la ligne II-II de la figure 1 ;
- figure 3, une vue schématique d'une partie de l'oscillateur de la figure 1 intégrant un circuit optique et un photodétecteur propres à convertir l'oscillation optique dans le domaine radiofréquence;
- figure 4, une vue schématique d'une autre partie de l'oscillateur de la figure 1 intégrant les boucles de stabilisation;
- figure 5, une vue schématique d'un champ magnétique appliqué sur le résonateur en anneau selon une première configuration ;
- figure 6, une vue schématique d'un champ magnétique appliqué sur le résonateur en anneau selon une deuxième configuration ;
- figure 7, une vue de graphique illustrant le mécanisme de l'effet Faraday sur le spectre du résonateur,
- figure 8, une vue schématique d'une partie d'un autre exemple d'oscillateur radiofréquence comportant un résonateur en anneau, et
- figure 9, une vue schématique d'une partie d'encore un autre exemple d'oscillateur radiofréquence comportant un résonateur en anneau.

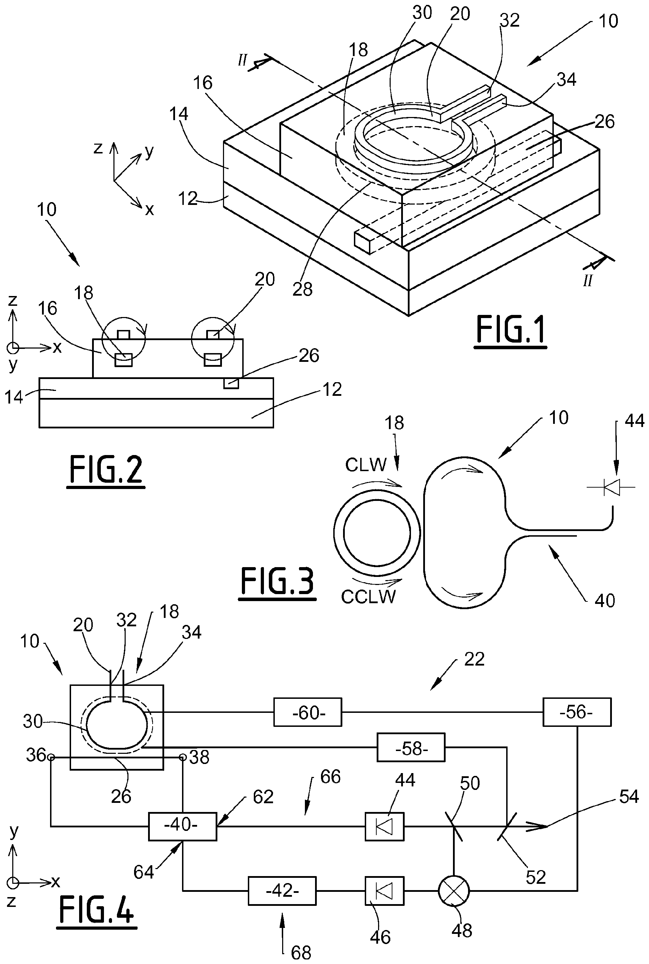

Un oscillateur 10 radiofréquence est représenté à la figure 1.

Un oscillateur 10 est un dispositif propre à générer des oscillations présentant une fréquence fixe ou contrôlée sur une ou plusieurs sortie(s).

Un oscillateur 10 est un oscillateur 10 radiofréquence lorsque la fréquence des oscillations est une radiofréquence, c'est-à-dire une fréquence comprise entre 3 kiloHertz (kHz) et 300 GHz.

L'oscillateur 10 est un empilement de couches notamment visibles aux figures 1 et 2.

Pour la suite, il est défini une direction d'empilement. La direction d'empilement est symbolisée sur les figures par un axe Z. La direction d'empilement est donc désignée par l'expression « direction d'empilement Z » dans le reste de la description.

Il est également défini une première direction transversale. Comme visible sur la figure 2, la première direction transversale est perpendiculaire à la direction d'empilement Z et contenue dans le plan de la feuille. La première direction transversale est symbolisée sur les figures par un axe X. La première direction transversale est donc désignée par l'expression « première direction transversale X » dans le reste de la description.

Une deuxième direction transversale est également définie comme étant perpendiculaire à la direction d'empilement Z et à la première direction transversale X. La deuxième direction transversale est symbolisée sur les figures par un axe Y. La deuxième direction transversale est donc désignée par l'expression « deuxième direction transversale Y » dans le reste de la description.

L'oscillateur 10 est donc un empilement de trois couches selon la direction d'empilement Z : une première couche 12, une deuxième couche 14 et une troisième couche 16.

La première couche 12 est un substrat silicium. De tels substrats en silicium permettent d'intégrer à la fois des composants optiques et des composants électroniques.

La deuxième couche 14 est intercalée entre la première couche 12 et la troisième couche 16.

La deuxième couche 14 est réalisée en un matériau diélectrique à bas indice optique.

Dans ce contexte, un matériau à bas indice optique est un matériau présentant, à une longueur d'ondes de 1,5 µm (micromètre), un indice inférieur à la couche guidante optique (résonateur) et idéalement proche de 1.

Selon l'exemple décrit, le matériau isolant est du SiO₂.

L'oscillateur 10 comporte un résonateur 18, un applicateur 20 de champ magnétique, un circuit de traitement 22 et un guide d'extraction 26.

Le résonateur 18 est un résonateur optique de type micro-anneau.

Autrement formulé, le résonateur 18 est un guide d'ondes présentant une forme en anneau. En variante, le résonateur 18 présente la forme d'un un micro-disque.

Par « anneau », il est entendu une forme d'anneau au sens large de sorte qu'un guide d'ondes présentant une forme sensiblement oblongue est considéré comme un anneau. Un tel guide d'ondes est souvent désigné sous l'appellation anglaise de « racetrack ».

Il est défini pour le résonateur 18 un premier rayon R1.

Il est également défini un centre pour le résonateur 18.

Le résonateur 18 permet la propagation d'une première onde dans un premier sens et d'une deuxième onde dans un deuxième sens, le deuxième sens étant opposé au premier sens.

La première onde dans le premier sens correspond à un mode se propageant dans le sens horaire. Ce mode est parfois désigné sous le sigle CLW pour l'anglais 'clockwise' qui signifie dans le sens horaire. Il est donc noté mode CLW dans la suite de la description.

La deuxième onde dans le deuxième sens correspond à un mode se propageant dans le sens antihoraire. Ce mode est parfois désigné sous le sigle CCLW pour l'anglais 'counterclockwise' qui signifie dans le sens anti-horaire. Il est donc noté mode CCLW dans la suite de la description.

Le résonateur 18 est en contact avec une partie réalisée en un matériau à effet magnéto-optique.

Par définition, un matériau magnéto-optique possède un indice de réfraction asymétrique. De ce fait, l'expression « matériau non-réciproque » est parfois utilisée pour désigner un tel type de matériau.

Typiquement n'importe quel matériau possédant une polarisation magnétique peut présenter cette propriété.

Par exemple, selon l'exemple décrit, le matériau à effet magnéto-optique est du grenat d'yttrium et de fer, de formule Y₃Fe₅O₁₂, communément désigné par son acronyme YIG.

En variante, le matériau à effet magnéto-optique est du YIG dopé avec un élément ferromagnétique, paramagnétique, ferrimagnétique ou métallique.

Par le terme « dopé », il est entendu une acceptation large incluant des substitutions avec les éléments précédemment mentionnés. Le dopage permet d'augmenter l'efficacité magnéto-optique du YIG.

Le ferromagnétisme désigne la capacité de certains corps de s'aimanter sous l'effet d'un champ magnétique extérieur et de garder une partie de cette aimantation.

Le paramagnétisme désigne en magnétisme le comportement d'un milieu matériel qui ne possède pas d'aimantation spontanée mais qui, sous l'effet d'un champ magnétique extérieur, acquiert une aimantation dirigée dans le même sens que ce champ d'excitation.

Le ferrimagnétisme est une propriété magnétique de certains corps solides. Dans un matériau ferrimagnétique, les moments magnétiques sont anti-parallèles mais d'amplitude différente. Il en résulte une aimantation spontanée du matériau.

Parmi les éléments magnétiques, le nickel, le cobalt, le fer ou un alliage de nickel-cobalt-fer présente un intérêt dans ce contexte.

Selon un exemple particulier, le matériau à effet magnéto-optique est du YIG dopé au cérium (souvent désigné par l'acronyme Ce:YIG) ou du YIG dopé au bismuth (souvent désigné par Bi:YIG).

Dans l'exemple de la figure 1, la partie réalisée en un matériau à effet magnéto-optique est la troisième couche 16.

Le résonateur 18 comporte en outre un milieu optique actif 28.

Le milieu optique actif 28 est propre à générer une première raie optique à partir de la première onde et une deuxième raie à partir de la deuxième onde.

Plus généralement, un milieu optique actif 28 est un milieu propre à générer du gain pour une onde traversant le milieu optique sur une gamme de longueur d'ondes prédéfinie.

Dans l'exemple représenté, le résonateur 18 en anneau est le milieu optique actif 28. Cela implique notamment que le milieu optique actif 28 est enchâssé dans la troisième couche 16.

Le milieu optique actif 28 est, par exemple, réalisé en matériau III-V.

On rappelle qu'un semi-conducteur de type « III - V » est un semi-conducteur composite fabriqué à partir d'un ou plusieurs éléments de la colonne III du tableau périodique des éléments (bore, aluminium, gallium, indium, ...) et d'un ou plusieurs éléments de la colonne V ou pnictogènes (azote, phosphore, arsenic, antimoine ...).

Par exemple, le milieu optique actif 28 est un puits quantique.

Le guide d'extraction 26 est couplé au résonateur optique 18.

Dans l'exemple de la figure 2, le guide d'extraction 26 présente une forme rectiligne et s'étend principalement le long de la deuxième direction transversale Y.

En variante, le guide d'extraction 26 présente une forme courbée (ou « poulie ») pour profiter d'un effet filtrage des autres modes se propageant dans le résonateur 18.

Selon le cas de la figure 1, le guide d'extraction 26 est un guide d'onde passif en silicium.

Le résonateur 18 est situé dans la troisième couche 16 alors que le guide d'extraction 26 fait partie de la deuxième couche 14.

L'applicateur 20 est un applicateur 20 de champ magnétique externe d'intensité réglable sur le résonateur 18 optique.

L'applicateur 20 est propre à générer un décalage en fréquence entre la première onde (CLW) et la deuxième onde (CCLW).

Dans l'exemple décrit, l'applicateur 20 est une boucle de courant.

En variante, l'applicateur comporte une pluralité de spires.

Plus précisément, comme visible sur la figure 1, l'applicateur 20 comporte une partie médiane 30 et deux plots d'alimentation 32 et 34.

Les deux plots d'alimentation 32 et 34 sont des portions rectilignes s'étendant le long de la deuxième direction transversale Y.

La partie médiane 30 présente une forme en anneau quasi-fermée reliant deux extrémités des deux plots d'alimentation 32 et 34.

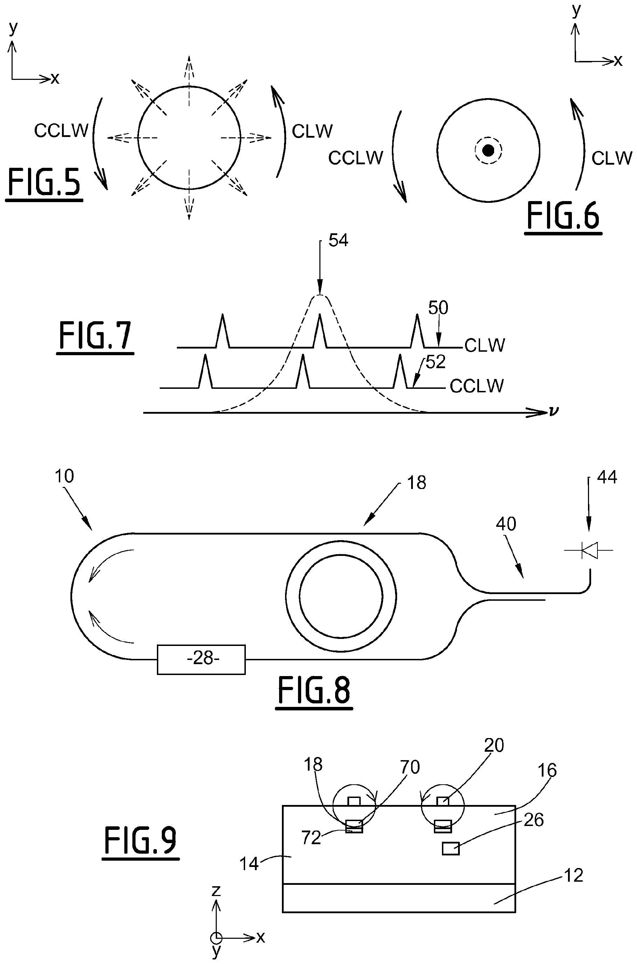

Comme visible sur la figure 5, l'applicateur 20 est adapté à appliquer un champ magnétique orienté radialement par rapport au centre du résonateur 18 en anneau lorsque les deux ondes se propagent selon une polarisation transverse magnétique

L'applicateur 20 est également adapté à appliquer un champ magnétique perpendiculaire au résonateur 18 en anneau lorsque les deux ondes se propagent selon une polarisation transverse électrique (voir figure 6).

L'applicateur 20 est déposé sur la troisième couche 16 ainsi que visible à la figure 2.

L'applicateur 20 est alimenté par une source de courant non représentée sur les figures.

Le circuit de traitement 22 est visible sur la figure 4.

Le circuit de traitement 22 est réalisé selon une technologie silicium.

Le circuit de traitement 22 assure plusieurs fonctions dans l'exemple de la figure 1, à savoir convertir le battement entre les deux raies optiques en un signal radiofréquence et assurer la stabilité en amplitude et en phase de l'oscillateur 10.

Le circuit de traitement 22 comporte deux entrées 36 et 38, un coupleur 40, une ligne à retard 42, deux détecteurs 44 et 46, un comparateur 48, deux séparateurs 50 et 52, une sortie 54, un filtre 56, un correcteur de gain 58 et un correcteur de phase 60.

Les deux entrées 36 et 38 du circuit de traitement 22 sont reliées d'une part au guide d'extraction 26 et d'autre part au coupleur 40.

Le coupleur 40 est un coupleur directionnel.

Le coupleur 40 comporte deux sorties 62 et 64 permettant de définir deux voies optiques 66 et 68.

En variante, au lieu du coupleur directionnel 40, un coupleur de type « MMI » est utilisé. Le sigle « MMI » renvoie au terme anglais « multimode interference » qui se traduit par le terme « interférence multimode » en français.

La première voie optique 66 est reliée au premier détecteur 44.

Le premier détecteur 44 est propre à convertir le battement entre les deux raies optiques en un signal radiofréquence.

Le premier détecteur 44 est ainsi un photodétecteur.

Par exemple, le premier détecteur 44 est une photodiode.

Dans l'exemple décrit, le premier détecteur 44 est réalisé dans une technologie silicium.

Dans le cas de la figure 4, le premier détecteur 44 est une photodiode de type silicium - germanium.

La deuxième voie optique 68 comporte la ligne à retard 42 et le deuxième détecteur 46.

La ligne à retard 42 est une ligne à retard optique introduisant un retard entre la première voie et la deuxième voie.

Par exemple, la ligne à retard 42 est une fibre optique.

En variante, la ligne à retard 42 est un guide d'ondes réalisé en SiN.

Le deuxième détecteur 46 est similaire au premier détecteur 44. Les remarques faites pour le premier détecteur 44 s'appliquent également pour le deuxième détecteur 46.

Le premier séparateur 50 est propre à séparer le signal issu du premier détecteur 44 en une partie du signal envoyée au comparateur 48 et une autre partie envoyée vers le deuxième séparateur 52.

Le comparateur 48 est propre à comparer les signaux des deux voies optiques 66 et 68, pour générer un signal de comparaison.

Le filtre 56 est propre à filtrer le signal de comparaison pour obtenir un signal filtré. Selon l'exemple décrit, le filtre 56 est un filtre passe-bas.

Le filtre 56 est relié au correcteur de phase 60.

Le correcteur de phase 60 est propre à contrôler le courant circulant dans l'applicateur 20.

Le correcteur de phase 60 est un circuit d'asservissement.

Le deuxième séparateur 52 est propre à séparer le signal issu du premier séparateur 50 en une partie envoyée vers le correcteur de gain 58 et une autre partie envoyée vers la sortie 54 du circuit de traitement 22.

La sortie 54 du circuit de traitement 22 correspond à la sortie de l'oscillateur 10.

Le correcteur de gain 58 est propre à contrôler le gain du milieu optique actif 28.

Le correcteur de gain 58 est, par exemple, un asservissement de type « PID », le sigle PID renvoyant à l'expression « proportionnel, intégrateur et dérivateur ».

Le fonctionnement de l'oscillateur 10 est maintenant décrit dans ce qui suit.

De manière simplifiée, deux ondes optiques, associées à un mode de résonance, circulent en sens opposé dans le résonateur 18 qui intègre le matériau magnéto-optique.

Comme illustré par la figure 7, l'application du champ magnétique, en modifiant la non-réciprocité du matériau, permet de contrôler l'écartement en fréquence des résonances d'un mode optique doublement dégénéré.

Le battement sur un détecteur 44 ou 46 des modes CLW et CCLW se propageant en sens opposé génère un signal périodique dans le domaine électrique.

Pour expliquer ce point, il convient de rappeler ici le principe de la synthèse de signaux par voie optique qui est un principe bien établi. Le spectre électrique du signal généré par une photodiode détectant l'émission des deux sources lasers est une sinusoïde dont la fréquence correspond à l'écartement spectral. Cette approche permet de couvrir une gamme de fréquences très importante allant du GigaHertz au TéraHertz, la seule limitation étant le temps de réponse du photodétecteur.

Les fluctuations de phase et d'amplitude de chaque source s'additionnent en amplitude si les sources ne sont pas corrélées, ce qui est le cas de deux sources lasers indépendantes.

En revanche, si les deux sources partagent la même cavité, les fluctuations sont les mêmes, dans la mesure où les deux modes sont les plus proches possibles, c'est-à-dire, présentent la distribution spatiale la plus proche.

Dans le cas d'un résonateur 18 en anneau, tout mode est doublement dégénéré en fréquence, selon la direction de propagation (comme les aiguilles de la montre, CLW, ou contre, CCLW). Le recouvrement entre ces deux modes est maximal. Les deux résonances sont strictement identiques et suivent les mêmes fluctuations, en l'absence d'effet non réciproque.

L'ajout d'un matériau à effet magnéto-optique (type Faraday) permet de lever la dégénérescence et d'obtenir un signal lors de la conversion dans le domaine électrique. Seules les fluctuations du champ magnétique se traduisent en une fluctuation de fréquence.

Dans le cas décrit, il existe deux configurations possibles d'application du champ comme visible aux figures 5 et 6.

Dans l'exemple de la figure 5, les deux modes CLW et CCLW se propagent selon une polarisation transverse magnétique. L'applicateur 20 applique alors un champ magnétique radial par rapport au centre du résonateur 18.

Selon le cas de la figure 6, les deux modes CLW et CCLW se propagent selon une polarisation transverse électrique. L'applicateur 20 applique alors un champ magnétique perpendiculaire au résonateur 18.

Dans chacun des cas, l'application d'un champ magnétique externe, orienté radialement pour une propagation transverse magnétique et orienté à la normale pour une propagation transverse électrique provoque une anisotropie responsable d'un décalage spectral de la résonance. Ce décalage a un signe opposé entre le premier mode CLW et le deuxième mode CCLW.

Dans les deux cas de figures, l'oscillateur 10 utilise un matériau magnéto-optique permettant de rendre non réciproque la propagation d'une onde optique dans le résonateur 18 suivant le sens de rotation. Le battement des deux fréquences optiques dans un détecteur rapide permet la conversion dans le domaine électrique. Ce mécanisme est notamment illustré par la figure 7 où le peigne de fréquence 50 associé au premier mode de propagation CLW, le peigne de fréquence 52 selon le deuxième mode CCLW et la courbe de gain 54 du milieu optique actif 28.

L'oscillateur 10 présente des propriétés en termes d'accordabilité similaire au cas du laser bi-fréquence.

L'oscillateur 10 permet de disposer d'une source compacte, c'est-à-dire une source présentant une taille et un encombrement fortement réduits.

De fait, la source est intégrable sur un circuit photonique intégré. Notamment, l'oscillateur 10 est de nature compatible avec une plateforme type photonique en silicium.

De plus, la technologie mise en œuvre, basée sur une circuiterie en photonique intégrée (sur silicium) sur laquelle sont reportés des éléments réalisés en des matériaux III-V et en un matériau non-réciproque magnétique, est compatible avec d'autres fonctionnalités intégrées sur la puce, offrant un large champ d'applications.

En outre, les modes contrapropagatif et copropagatif ayant pour origine le même mode (dégénéré par le champ magnétique), le recouvrement des deux modes est quasi-parfait, ce qui conduit à une corrélation du bruit améliorée.

Autrement formulé, les modes associés aux deux sens de propagation, étant quasi-dégénérés, sont par essence très proches et, partageant le même milieu, vont subir les mêmes fluctuations environnementales. Etant corrélés, la différence de fréquence voit son bruit fortement réduit.

Par ailleurs, l'oscillateur 10 présente un bruit de phase réduit et un bruit d'amplitude réduit, de sorte que l'oscillateur 10 est plus stable.

L'oscillateur 10 est, en outre, reconfigurable rapidement puisque le contrôle est effectué par le contrôle du courant dans l'applicateur 20.

Il est ainsi proposé un oscillateur 10 radiofréquence intégré, agile et à grande pureté spectrale, par l'utilisation d'un matériau magnéto-optique qui est aisé à fabriquer.

Notamment, les techniques utilisées traditionnellement dans le domaine de la photonique intégrée suffisent pour fabriquer un tel oscillateur 10. Typiquement, le résonateur 18 est collé sur une puce en silicium et un deuxième report ou un dépôt direct permet de disposer le matériau à effet magnéto-optique.

La figure 8 présente un autre mode de réalisation de l'oscillateur 10.

L'oscillateur 10 selon la figure 8 est similaire à l'oscillateur 10 selon la figure 1 de sorte que seules les différences sont précisées dans ce qui suit. Les remarques s'appliquant à la fois aux oscillateurs 10 de la figure 1 et de la figure 8 ne sont pas répétées dans ce qui suit.

Le milieu optique actif 28 est positionné de manière à ce que le résonateur 18 soit une cavité étendue.

Cela signifie que le milieu actif 28 est positionné hors du guide d'ondes en anneau. Dans une telle configuration, le résonateur 18 comporte deux parties distinctes : le guide d'ondes en anneau et le milieu actif 28, l'ensemble formant une cavité étendue.

Cette configuration permet pour certaines applications d'augmenter la puissance du laser au niveau de la zone de gain.

En outre, il est envisageable d'utiliser d'un guide d'extraction 26 en nitrure autorisant des densités de puissance supérieures.

La figure 9 présente un autre mode de réalisation de l'oscillateur 10.

L'oscillateur 10 selon la figure 9 est similaire à l'oscillateur 10 selon la figure 1 de sorte que seules les différences sont précisées dans ce qui suit. Les remarques s'appliquant à la fois aux oscillateurs 10 de la figure 1 et de la figure 9 ne sont pas répétées dans ce qui suit.

Dans le mode de réalisation de la figure 9, la deuxième couche 14 et la troisième couche 16 sont confondues et réalisées en un matériau diélectrique de bas indice.

Le résonateur 18 est un guide d'ondes en anneau comportant une première partie 70 et une deuxième partie 72. Les deux parties 70 et 72 ont la même forme en anneau.

La première partie 70 surmonte la deuxième partie 72, les deux parties 70 et 72 étant en contact sur l'ensemble de l'anneau.

La première partie 70 est réalisée en matériau III-V tandis que la deuxième partie 72 est réalisée en matériau magnétique-optique.

De manière générale, la partie en matériau magnétique-optique est positionnée de manière à influencer l'onde optique se propageant dans le guide d'ondes en anneau, soit en modifiant la partie évanescente du champ optique (cas notamment de la figure 1), soit en modifiant directement la structure guidante (cas de la figure 9).

La modification directe de la structure guidante permet de maximiser l'effet anisotrope car les modes optiques ont alors un très bon recouvrement avec le milieu Faraday.

L'oscillateur 10 présenté est avantageusement utilisable pour de nombreuses applications.

Notamment, dans un exemple particulier, une source radiofréquence comporte un tel oscillateur 10.

La source est alors utilisable pour des appareils électroniques tels que des synthétiseurs de fréquence, des analyseurs de spectre électrique et oscillateurs locaux pour les récepteurs cohérents.

L'invention concerne également toutes les combinaisons techniquement possibles des modes de réalisation précédemment décrits.

## Revendications

1. Oscillateur (10) radiofréquence comprenant :
- un résonateur (18) optique étant un guide d'ondes en anneau permettant la propagation d'une première onde dans un premier sens et d'une deuxième onde dans un deuxième sens, le deuxième sens étant opposé au premier sens, et le résonateur (18) comportant un milieu optique actif (28) générant une première raie optique à partir de la première onde et une deuxième raie à partir de la deuxième onde,
le résonateur (18) étant en contact avec une partie réalisée en un matériau à effet magnéto-optique,
- un applicateur (20) de champ magnétique externe d'intensité réglable sur le résonateur (18) générant un décalage en fréquence entre la première onde et la deuxième onde, et
- un circuit de traitement (22) convertissant le battement entre les deux raies optiques en un signal radiofréquence.

2. Oscillateur selon la revendication 1, dans lequel le matériau à effet magnéto-optique est du grenat d'yttrium et de fer ou du grenat d'yttrium et de fer dopé avec un élément ferromagnétique, paramagnétique, ferrimagnétique ou métallique.

3. Oscillateur selon la revendication 1 ou 2, dans lequel le circuit de traitement (22) est réalisé dans une technologie silicium.

4. Oscillateur selon l'une quelconque des revendications 1 à 3, dans lequel l'applicateur (20) est adapté à appliquer un champ magnétique perpendiculaire au guide d'ondes en anneau lorsque les deux ondes se propagent selon une polarisation transverse électrique.

5. Oscillateur 10 selon l'une quelconque des revendications 1 à 4, dans lequel il est défini un centre pour le résonateur (18), l'applicateur (20) étant adapté à appliquer un champ magnétique radial par rapport au centre du résonateur (18) lorsque les deux ondes se propagent selon une polarisation transverse magnétique.

6. Oscillateur selon l'une quelconque des revendications 1 à 5, dans lequel la partie réalisée en un matériau à effet magnéto-optique fait partie du résonateur (18) et est en contact avec le milieu optique actif (28).

7. Oscillateur selon l'une quelconque des revendications 1 à 6, dans lequel l'oscillateur (10) comporte, en outre, une stabilisation en amplitude en fréquence et en phase.

8. Oscillateur selon l'une quelconque des revendications 1 à 7, dans lequel le milieu optique actif (28) est positionné de manière à ce que le résonateur (18) soit une cavité étendue.

9. Source radiofréquence comportant un oscillateur (10) radiofréquence selon l'une quelconque des revendications 1 à 8.

10. Appareil comportant une source radiofréquence selon la revendication 9.

## Patentansprüche

1. Funkfrequenz-Oszillator (10), welcher aufweist:
- einen optischen Resonator (18), welcher ein Ringwellenleiter ist, welcher die Ausbreitung einer ersten Welle in einer ersten Richtung und einer zweiten Welle in einer zweiten Richtung erlaubt, wobei die zweite Richtung entgegengesetzt zur ersten Richtung ist, und wobei der Resonator (18) ein aktives optisches Medium (28) aufweist, welches eine erste optische Linie ausgehend von der ersten Welle und eine zweite Linie ausgehend von der zweiten Welle erzeugt, wobei der Resonator (18) in Kontakt mit einem Abschnitt ist, welcher aus einem Material mit magneto-optischem Effekt hergestellt ist,
- einen Applikator (20) für ein externes Magnetfeld mit einer einstellbaren Intensität auf den Resonator (18), welcher eine Frequenzverschiebung zwischen der ersten Welle und der zweiten Welle erzeugt, und
- einen Verarbeitungsschaltkreis (22), welcher die Schwebung zwischen den beiden optischen Linien in ein Funkfrequenzsignal umwandelt.

2. Oszillator gemäß Anspruch 1, wobei das Material mit magneto-optischem Effekt Yttrium-Eisen-Granat oder Yttrium-Eisen-Granat, welches mit einem ferromagnetischen, paramagnetischen, ferrimagnetischen oder metallischen Element dotiert ist, ist.

3. Oszillator gemäß Anspruch 1 oder 2, wobei der Verarbeitungsschaltkreis (22) in einer Siliziumtechnologie hergestellt ist.

4. Oszillator gemäß irgendeinem der Ansprüche 1 bis 3, wobei der Applikator (20) angepasst ist, um ein Magnetfeld anzulegen, welches senkrecht zum Ringwellenleiter ist, wenn sich die beiden Wellen gemäß einer elektrischen Transversalpolarisation ausbreiten.

5. Oszillator 10 gemäß irgendeinem der Ansprüche 1 bis 4, wobei ein Zentrum für den Resonator (18) definiert ist, wobei der Applikator (20) angepasst ist, um ein Magnetfeld anzulegen, welches bezüglich des Zentrums des Resonators (18) radial ist, wenn sich die beiden Wellen gemäß einer magnetischen Transversalpolarisation ausbreiten.

6. Oszillator gemäß irgendeinem der Ansprüche 1 bis 5, wobei der Abschnitt, welcher aus einem Material mit magneto-optischem Effekt hergestellt ist, ein Teil des Resonators (18) ist und in Kontakt mit dem aktiven optischen Medium (28) ist.

7. Oszillator gemäß irgendeinem der Ansprüche 1 bis 6, wobei der Oszillator (10) ferner eine Amplituden-, Frequenz- und Phasenstabilisierung aufweist.

8. Oszillator gemäß irgendeinem der Ansprüche 1 bis 7, wobei das aktive optische Medium (28) auf eine Weise angeordnet ist, dass der Resonator (18) eine erweiterte Kavität ist.

9. Funkfrequenz-Quelle, welche einen Funkfrequenz-Oszillator (10) gemäß irgendeinem der Ansprüche 1 bis 8 aufweist.

10. Vorrichtung, welche eine Funkfrequenz-Quelle gemäß Anspruch 9 aufweist.

## Claims

1. Radiofrequency oscillator (10) comprising:
- an optical resonator (18) being a ring waveguide allowing propagation of a first wave in a first direction and of a second wave in a second direction, the second direction being opposite to the first direction, and the resonator (18) comprising an active optical medium (28) generating a first optical line from the first wave and a second line from the second wave,
- the resonator (18) being in contact with a part made of a material featuring a magneto-optic effect,
- an external magnetic field applier (20) of adjustable intensity on the resonator (18) generating a frequency offset between the first wave and the second wave, and
- a processing circuit (22) converting the beat between the two optical lines into a radiofrequency signal.

2. An oscillator according to claim 1, in which the material featuring a magneto-optic effect is yttrium and iron garnet or yttrium and iron garnet doped with a ferromagnetic, paramagnetic, ferrimagnetic or metallic element.

3. Oscillator according to claim 1 or 2, wherein the processing circuit (22) is made using silicon technology.

4. Oscillator according to any one of claims 1 to 3, wherein the applier (20) is adapted to apply a magnetic field perpendicular to the ring waveguide when the two waves propagate in electrical transverse polarization.

5. Oscillator 10 according to any one of claims 1 to 4, in which a center is defined for the resonator (18), the applier (20) being adapted to apply a radial magnetic field relative to the center of the resonator (18) when the two waves propagate in transverse magnetic polarization.

6. Oscillator according to any one of claims 1 to 5, wherein the part made of a material featuring a magneto-optic effect is part of the resonator (18) and is in contact with the active optical medium (28).

7. Oscillator according to any one of claims 1 to 6, wherein the oscillator (10) further comprises stabilization in amplitude in frequency and in phase.

8. Oscillator according to any one of claims 1 to 7, in which the active optical medium (28) is positioned so that the resonator (18) is an extended cavity.

9. Radiofrequency source comprising a radiofrequency oscillator (10) according to any one of claims 1 to 8.

10. Device comprising a radiofrequency source according to claim 9.
